# EUROPÄISCHE PATENTSCHRIFT

(11) **EP 0 496 207 B1**
(45) Veröffentlichungstag und Bekanntmachung des Hinweises auf die Patenterteilung: **14.05.1997**
(21) Anmeldenummer: 92100192.1
(22) Anmeldetag: 08.01.1992
(51) Int. Cl.: G01R 1/073

(54) **Prüfvorrichtung für integrierte Schaltkreise**
Testing device for integrated circuits
Dispositif pour tester des circuits intégrés

(30) Priorität: 23.01.1991 DE 4101920
(43) Veröffentlichungstag der Anmeldung: 29.07.1992
(73) Patentinhaber: Ehlermann, Eckhard, Dr., D-80796 München (DE)
(72) Erfinder: Ehlermann, Eckhard, Dr., D-80796 München (DE)
(74) Vertreter: Tiedtke, Harro, Dipl.-Ing.

(56) Entgegenhaltungen:
- EP-A- 0 131 375
- US-A- 3 551 807
- PATENT ABSTRACTS OF JAPAN vol. 8, no. 1 (P-246)(1438) 6. Januar 1984 & JP-A-58 165 056

## Beschreibung

Die Erfindung bezieht sich auf eine Prüfvorrichtung für integrierte Schaltkreise, die die Verbindung vom Prüfgerät zu den Lande plätzen des Schaltkreises herstellt.

Bei solchen Prüfvorrichtungen werden eine Vielzahl von Kontaktnadeln, die auf einer scheibenartigen Prüfkarte montiert sind, mit den Landeplätzen (pads) des integrierten Schaltkreises in Kontakt gebracht. Von den Nadeln her wird über gedruckte Leiterbahnen und Anschlußelemente auf der Karte der elektrische Kontakt zum Prüfgerät hergestellt. Ist der integrierte Schaltkreis auf diese Weise mit dem Prüfgerät verbunden, können seine Funktionen bei unterschiedlichsten Klimabedingungen, dh. beispielsweise bei unterschiedlicher Umgebungstemperatur oder Luftfeuchtigkeit, getestet werden.

Aus der EP-A-0 131 375 ist eine Prüfvorrichtung für integrierte Schaltkreise bekannt, bei der eine Verbindung vom Prüfgerät zu den Landeplätzen (pads) des integrierten Schaltkreises hergestellt wird. Diese Prüfvorrichtung verfügt über eine Prüfkarte, die elektrische Anschlüsse für das Prüfgerät aufweist und über Kontaktnadeln verfügt, mittels denen der Kontakt zu den Landeplätzen (pads) des integrierten Schaltkreises hergestellt wird. Die Kontaktnadeln sind an einem Halteteil gelagert, das mittels einer Halterung fest mit der Prüfkarte verbunden ist. Für das Halteteil wird in dieser Schrift ein Material mit geringem Temperaturkoeffizienten vorgeschlagen.

Aus der US 3,551,807 ist ein Prüfgerät zum Überprüfen integrierter Schaltkreise bekannt, bei dem der Kontakt zwischen den Landeplätzen (pads) des integrierten Schaltkreises und dem Prüfgerät ebenfalls über Kontaktnadeln hergestellt wird. Diese Kontaktnadeln sind einzeln an Trägern gelagert, die wiederum mittels einer Halterung von einem ringartigen Bauelement getragen werden. Über eine geeignete Halterung wird bei dieser Prüfvorrichtung eine gewisse Relativbewegung zwischen den einzelnen Nadelträgern und dem ringartigen Bauelement zugelassen.

Aus der US-PS 4 599 559 ist eine Prüfvorrichtung bekannt, bei der eine ringförmige Scheibe aus einem elektrisch nicht leitendem Material an dem Prüfgerät montiert wird; über Anschlüsse auf der Scheibe wird diese elektrisch mit dem Prüfgerät verbunden. Am inneren Umfang der ringförmigen Scheibe ist ein Keramikring vorgesehen, der die Nadeln trägt. Die Nadeln sind mit auf die Scheibe aufgedruckten Leiterbahnen verbunden, die in den Anschlußelementen für die Zuleitungen des Prüfgerätes enden.

Jedoch treten auch bei dieser Prüfvorrichtung Probleme mit temperaturbedingter Verformung der Scheibe auf. Soll der integrierte Schaltkreis beispielsweise in einem Temperaturbereich von - 40 Grad Celsius bis + 100 Grad Celsius getestet werden, kommt es über diesen Temperaturbereich zu Verformungen der Scheibe. Der mittige Keramikring ist zwar in der Lage, Ausdehnungen und Schrumpfungen zu behindern, jedoch wirft sich die am Prüfgerät montierte Scheibe auf, so daß die Positionierung des Keramikrings nicht eingehalten werden kann.

Um die Landeplätze (pads) des integrierten Schaltkreises nicht zu beschädigen, dürfen die Nadeln die Landeplätze (pads) nur mit geringem Druck belasten, dies führt dazu, daß bereits bei geringfügiger Schiefstellung des Keramikrings zur Ebene der Landeplätze (pads), einzelne Nadeln von ihren Landeplätzen (pads) abgehoben werden.

Auch kann eine Relativbewegung zwischen Nadel und Landeplatz (pad), aufgrund von Verformungen der Prüfkarte, zu Beschädigungen der Ländeplätze (pads) führen.

Prüfabläufe über einen großen Temperaturbereich werden daher häufig mit unterschiedlichen Prüfkarten durchgeführt, die jeweils bei Ihren Einsatztemperaturen die erforderliche Nadel-Geometrie aufweisen. Dies stellt jedoch einen hohen Prüfaufwand dar.

Aufgabe der Erfindung ist es, eine Prüfvorrichtung zu schaffen, bei der über einen weiten Einsatzbereich, insbesondere über einen großen Temperaturbereich, die Geometrie der Kontaktnadeln zueinander, sowie deren Lage zur Ebene der Landeplätze (pads) des integrierten Schaltkreises eingehalten wird.

Diese Aufgabe wird durch die Merkmale des Patentanspruch 1 gelöst. Mit diesen Merkmalen wird eine Konstruktion geschaffen wird, bei der das die Nadeln tragende Halteteil von der Prüfkarte weitgehend mechanisch entkoppelt ist, so daß zumindest ein Teil der Prüfkarte eine Relativbewegung zu dem Halteteil ausführen kann, ohne daß dadurch die Positionierung des Halteteils und damit der Nadeln wesentlich beeinträchtigt wird.

Hierzu wird das Halteteil gemäß dem Ausführungsbeispiel nur an einer Stelle mit der Prüfkarte fest verbunden. An den weiteren Befestigungsstellen ist das Halteteil so gelagert, daß es in der Kartenebene, die in der Regel horizontal ausgerichtet wird, verschieblich lediglich senkrecht dazu also vertikal gehalten ist. Dadurch wird über die feste Verbindung die Position des Halteteils festgelegt.

Temperaturbedingte Ausdehnungen bzw. Schrumpfungen der Prüfkarte werden durch die verschiebliche Halterung nicht behindert, ein Aufwerfen der Prüfkarte tritt nicht ein.

Eine solche, die gewünschten Relativbewegungen zulassende Lagerung des Halteteils kann dabei auf verschiedenste Weise realisiert werden. Beispielsweise kann das Halteteil an einer Stelle punktuell mit einem formschlüssigen Befestigungsmittel festgelegt werden und an weiteren Stellen schienenartig horizontal geführt werden oder mittels einer elastischen Klebstoffschicht gehalten werden.

Die feste Verbindung von Halteteil und Prüfkarte ist dabei vorteilhaft in der Nähe der Prüfkartenaufnahme am Prüfgerät vorzusehen.

Da integrierte Schaltkreise zumeist aus einem halbleitenden Basismaterial bestehen, weisen diese eine ausgesprochen geringe Temperaturdehnung auf. Daher sollte das Halteteil ebenfalls aus einem Material bestehen, das ebenfalls nur eine geringfügige Temperaturdehnung aufweist, beispielsweise keramische oder Werkstoffe wie Aluminium-Oxid, wobei sich auch Sandwichkonstruktionen gut eignen. Dabei kann das Halteteil auch mehrstückig ausgeführt sein. Allgemein sollte das Halteteil in seinem Klimaverhalten bezüglich des zu prüfenden Bereichs an das Verhalten des zu prüfenden Schaltkreises angepaßt sein.

Das Halteteil kann auch austauschbar sein, wodurch die Vorrichtung leicht an Schaltkreise unterschiedlichen Klimaverhaltens angepaßt werden kann.

Fig. 1 zeigt ein erstes Ausführungsbeispiel der Prüfvorrichtung von unten gesehen.

Fig. 2 zeigt die Prüfvorrichtung im Querschnitt.

Fig. 3 zeigt ein zweites Ausführungsbeispiel der Prüfvorrichtung von unten gesehen.

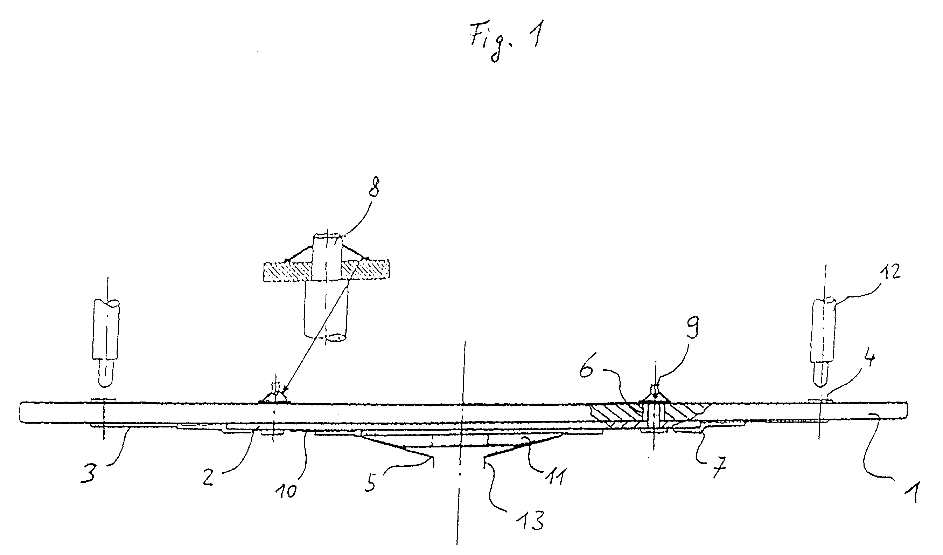

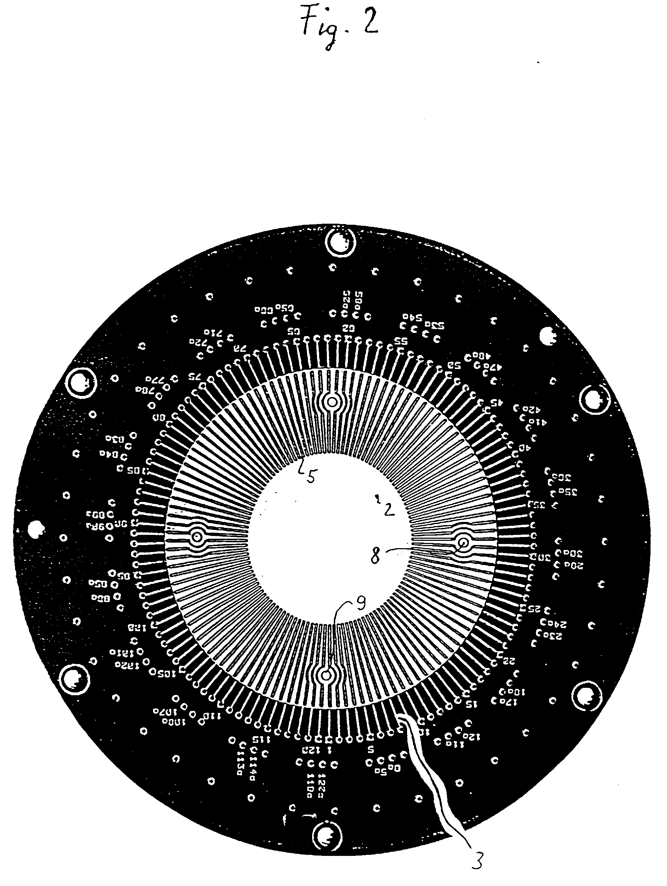

Die Prüfvorrichtung wird folgend unter Bezugnahme auf die Figuren 1 und 2 beschrieben.

Die Prüfkarte 1 trägt auf ihrer Unterseite aufgedruckte Leiterbahnen 3, die auf der Oberseite in Anschlüssen 4 enden, mit denen die Prüfkarte 1 an Anschlußstecker 12 des Prüfgerätes ansteckbar ist. In der Mitte der ringförmigen Prüfkarte 1 ist ein ringförmiges flächiges

Halteteil 2, das zweistückig aus einem äußeren Teil 10 und einen inneren Ring 11 besteht, mit radial gerichteten Kontaktnadeln 5 zu sehen.

Das Halteteil 2 ist dabei mittels Stiften 8,9 an der Prüfkarte befestigt. Die Kontaktnadeln 5 weisen am inneren Umfang der Vorrichtung abgewinkelte Spitzen 13 auf, die mit den Landeplätzen (pads) des Schaltkreises - nicht dargestellt - in Kontakt bringbar sind. Die Kontaktnadeln 5 sind an dem Halteteil 2 befestigt und über Dehnungsabschnitte 7 mit den Leiterbahnen 3 der Prüfkarte 1 verbunden.

Die Befestigung des Halteteils 2 an der Prüfkarte ist dabei so gestaltet, daß ein Stift 8 eine feste Verbindung von Prüfkarte 1 und Halteteil 2 schafft. Die weiteren Stifte 9 sitzen dabei in Löchern 6 der Prüfkarte 1, die größer als der Stiftdurchmesser sind, so daß in deren Bereich in der Ebene der Prüfkarte 1 eine Relativbewegung zwischen Prüfkarte 1 und Halteteil 2 möglich ist.

Die Prüfkarte 1 wird an das Prüfgerät angeschlossen und auf den Schaltkreis abgesenkt, bis ein elektrisch leitender Kontakt zwischen Kontaktnadeln 5 und Landeplätzen (pads) hergestellt ist. Tritt während des anschließenden Prüfprogramms eine Dehnung der Prüfkarte 1 auf, so kann sich diese gegenüber dem Halteteil 2 verschieben, ohne daß dessen Position nennenswert verändert wird.

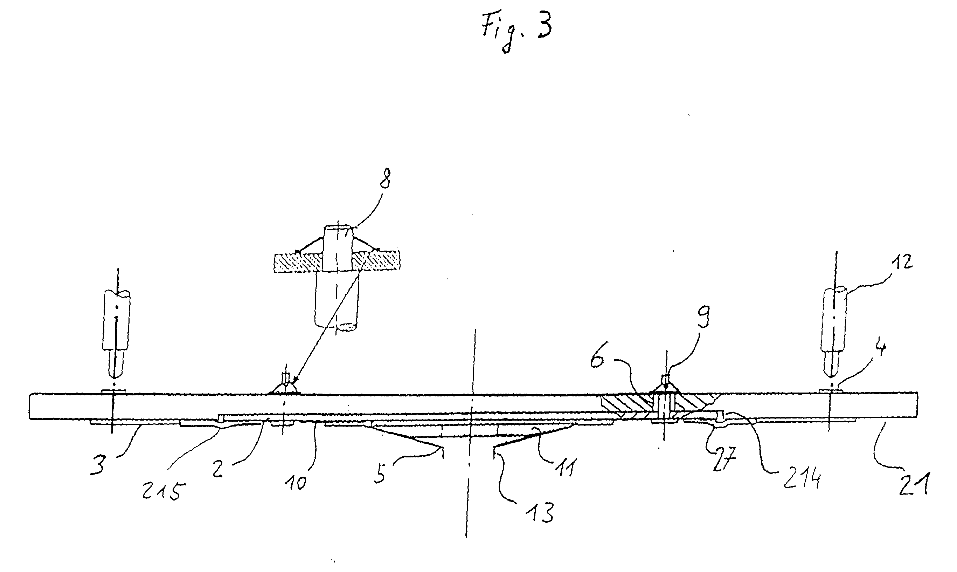

Gemäß dem Ausführungsbeispiel nach Figur 3 ist die Prüfkarte 21 in ihrem Zentrum mit einer scheibenartigen Ausnehmung 214 zur bündigen Aufnahme des Halteteils 2 versehen, das mit zwei Stiften 8,9 an der Prüfkarte 21 befestigt ist. Die Dehnungsabschnitte 27 sind an die bündige Montage des Halteteils 2 angepaßt und mit einem flexiblen Dehnungsbereich 215 versehen.

## Patentansprüche

1. Prüfvorrichtung für integrierte Schaltkreise, die die Verbindung vom Prüfgerät zu den Landeplätzen (pads) des integrierten Schaltkreises herstellt, mit einer Prüfkarte (1, 21), die die elektrischen Anschlüsse (4) für das Prüfgerät aufweist, die leitend mit einer Vielzahl von Kontaktnadeln (5) verbunden sind, die mit den Landeplätzen (pads) in Kontakt bringbar sind, wobei die Kontaktnadeln (5) in einem Halteteil (2) gehaltert sind, das an einer Stelle mittels eines Befestigungselements (8) zumindest in einer Bewegungsrichtung des Halteteils fest mit der Prüfkarte (1) verbunden ist und mittels weiterer Befestigungselemente (9) in der Kartenebene verschieblich mit der Prüfkarte (1) verbunden ist, um eine Relativbewegung zumindest eines Teils der Prüfkarte (1) relativ zum Halteteil (2) zuzulassen.

2. Prüfvorrichtung für integrierte Schaltkreise nach Anspruch 1, **dadurch gekennzeichnet,** daß das Halteteil (2) so beschaffen ist, daß es in dem Klimabereich, in dem der integrierte Schaltkreis geprüft werden soll, nur minimale Ausdehnungen bzw. Verformungen aufweist.

3. Prüfvorrichtung für integrierte Schaltkreise nach Anspruch 1 oder 2, **dadurch gekennzeichnet,** daß das Halteteil (2) bezüglich seines Ausdehnungsverhaltens an den zu prüfenden integrierten Schaltkreis angepaßt ist.

4. Prüfvorrichtung für integrierte Schaltkreise nach einem der Ansprüche 1 bis 3, **dadurch gekennzeichnet,** daß die Prüfkarte (1, 21) und das Halteteil (2) scheibenförmige Gestalt haben.

5. Prüfvorrichtung für integrierte Schaltkreise nach einem der Ansprüche 1 bis 4, **dadurch gekennzeichnet**, daß die Kontaktnadeln (5) über auf die Prüfkarte (1, 21) aufgebrachte Leiterbahnen (3) mit den elektrischen Anschlüssen (4) verbunden sind.

6. Prüfvorrichtung für integrierte Schaltkreise nach einem der Ansprüche 1 bis 5, **dadurch gekennzeichnet,** daß das Halteteil (2) austauschbar ist.

7. Prüfvorrichtung für integrierte Schaltkreise nach einem der Ansprüche 1 bis 6, **dadurch gekennzeichnet,** daß das Halteteil (2) an einer Stelle mittels eines Befestigungselements (8) in allen Bewegungsrichtungen des Halteteils fest mit der Prüfkarte (1) verbunden ist.

8. Prüfvorrichtung für integrierte Schaltkreise nach Anspruch 7, **dadurch gekennzeichnet,** daß das Halteteil (2) über Stifte (8, 9) mit der Prüfkarte (1) verbunden ist.

9. Prüfvorrichtung für integrierte Schaltkreise nach einem der Ansprüche 1 bis 8, **dadurch gekennzeichnet,** daß das Halteteil (2) aus einem keramischen Werkstoff besteht.

10. Prüfvorrichtung für integrierte Schaltkreise nach einem der Ansprüche 1 bis 9, **dadurch gekennzeichnet,** daß die Kontaktnadeln (5) über Dehnungsabschnitte (7, 27) mit den Leiterbahnen (3) verbunden sind.

11. Prüfvorrichtung für integrierte Schaltkreise nach Anspruch 10, **dadurch gekennzeichnet,** daß die Dehnungsabschnitte (7, 27) sich vom Halteteil (2) auf die Prüfkarte (1, 21) erstrecken.

12. Prüfvorrichtung für integrierte Schaltkreise nach einem der Ansprüche 1 bis 10, **dadurch gekennzeichnet,** daß das Halteteil (2) in eine Einsenkung (214) der Prüfkarte (21) eingesetzt ist.

## Claims

1. Device for testing integrated circuits which establishes the connection between the instrument and the circuit's pads, with a test card (1, 21) that has electrical connectors (4) for the instrument conductively connected with a large number of contact needles (5) that can be contacted with the pads, whereby the needles (5) are secured in a needle holder (2), which is, at least in one movement direction of the needle holder, rigidly connected to the test card (1) at one point by a fastener (8), and connected to the test card (1) by other fasteners (9) in such a way that it is displaceable in the plane of the test card (1) in order to allow at least part of the test card (1) to move in relation to the needle holder (2).

2. Device for testing integrated circuits as in claim 1, characterized in that the needle holder (2) expands or deforms only minimally in the climatic range in which the circuit is to be tested.

3. Device for testing integrated circuits as in claim 1 or 2, characterized in that the expansion behavior of the needle holder (2) matches that of the integrated circuit.

4. Device for testing integrated circuits as in one of claims 1 through 3, characterized in that the test card (1, 21) and needle holder (2) are disk-shaped.

5. Device for testing integrated circuits as in one of claims 1 through 4, characterized in that the needles (5) are connected to the pads or pins (4) by way of printed circuits (3) printed on the test card (1, 21).

6. Device for testing integrated circuits as in one of claims 1 through 5, characterized in that the needle holder (2) can be replaced.

7. Device for testing integrated circuits as in one of claims 1 through 6, characterized in that the needle holder (2) is, in all movement directions of the needle holder (2), rigidly fastened to the test card (1) at one point by a fastener (8).

8. Device for testing integrated circuits as in claim 7, characterized in that the needle holder (2) is secured to the test card (1) by rivets (8, 9).

9. Device for testing integrated circuits as in one of claims 1 through 8, characterized in that the needle holder (2) is ceramic.

10. Device for testing integrated circuits as in one of claims 1 through 9, characterized in that the needles (5) are connected to the printed circuits (3) by expanding sections (7, 27).

11. Device for testing integrated circuits as in claim 10, characterized in that the expanding sections (7, 27) extend from the needle holder (2) to the test card (1, 21).

12. Device for testing integrated circuits as in one of claims 1 through 10, characterized in that the needle holder (2) is inserted in a depression (214) in the test card (21).

## Revendications

1. Dispositif d'essai pour circuits intégrés, qui établit une liaison entre l'appareil d'essai et les plages de connexion du circuit intégré, comportant une carte d'essai (1, 21), qui présente les connexions électriques (4) pour l'appareil d'essai, qui sont reliées de manière conductrice à une pluralité de broches de contact (5), lesquelles broches peuvent être mises en contact avec les plages de connexion, les broches de contact (5) étant bloquées dans un élément de retenue (2), qui est fermement relié en un emplacement à la carte d'essai (1), à l'aide d'un élément de fixation (8), au moins dans un sens de déplacement de l'élément de retenue, et qui est relié, de manière mobile dans le plan de la carte, à la carte d'essai (1), à l'aide d'autres éléments de fixation (9), afin de permettre un mouvement relatif du moins d'une partie de la carte d'essai (1) par rapport à l'élément de retenue (2).

2. Dispositif d'essai pour circuits intégrés selon la revendication 1, **caractérisé en ce que** l'élément de retenue (2) est réalisé de telle manière qu'il ne présente que des déformations ou des dilatations minimales dans la plage des conditions climatiques, dans lesquelles le circuit intégré doit être soumis à l'essai.

3. Dispositif d'essai pour circuits intégrés selon la revendication 1 ou 2, **caractérisé en ce que** l'élément de retenue (2) est adapté, quant à sa tenue à la dilatation, au circuit intégré à soumettre à l'essai.

4. Dispositif d'essai pour circuits intégrés selon l'une des revendications 1 à 3, **caractérisé en ce que** la carte d'essai (1, 21) et l'élément de retenue (2) sont réalisés en forme de disque.

5. Dispositif d'essai pour circuits intégrés selon l'une des revendications 1 à 4, **caractérisé en ce que** les broches de contact (5) sont reliées aux connexions électriques (4), par l'intermédiaire de pistes conductrices (3) situées sur la carte d'essai (1, 21).

6. Dispositif d'essai pour circuits intégrés selon l'une des revendications 1 à 5, **caractérisé en ce que** l'élément de retenue (2) est échangeable.

7. Dispositif d'essai pour circuits intégrés selon l'une des revendications 1 à 6, **caractérisé en ce que** l'élément de retenue (2) est fermement relié en un emplacement à la carte d'essai (1), à l'aide d'un élément de fixation (8), et ce, dans tous les sens de déplacement de l'élément de retenue.

8. Dispositif d'essai pour circuits intégrés selon la revendication 7, **caractérisé en ce que** l'élément de retenue (2) est relié à la carte d'essai (1) par l'intermédiaire de broches de positionnement (8, 9).

9. Dispositif d'essai pour circuits intégrés selon l'une des revendications 1 à 8, **caractérisé en ce que** l'élément de retenue (2) consiste en une matière céramique

10. Dispositif d'essai pour circuits intégrés selon l'une des revendications 1 à 9, **caractérisé en ce que** les broches de contact (5) sont reliées aux pistes conductrices (3) par l'intermédiaire de tronçons de dilatation (7, 27).

11. Dispositif d'essai pour circuits intégrés selon la revendication 10, **caractérisé en ce que** les tronçons de dilatation (7, 27) s'étendent à partir de l'élément de retenue (2) jusque sur la carte d'essai (1, 21).

12. Dispositif d'essai pour circuits intégrés selon l'une des revendications 1 à 10, **caractérisé en ce que** l'élément de retenue (2) est logé dans un renfoncement (214) de la carte d'essai (21).
